# EUROPÄISCHE PATENTSCHRIFT

(11) **EP 3 591 345 B1**
(45) Veröffentlichungstag und Bekanntmachung des Hinweises auf die Patenterteilung: **11.11.2020**
(21) Anmeldenummer: 18181111.8
(22) Anmeldetag: 02.07.2018
(51) Int. Cl.: G01D 5/347, G01D 11/24, H01L 33/00, G01D 5/244, H01L 25/075, H01L 25/16

(54) **VERFAHREN ZUR HERSTELLUNG EINER LICHTQUELLE FÜR EINE SENSOREINHEIT EINER POSITIONSMESSEINRICHTUNG SOWIE EINE POSITIONSMESSEINRICHTUNG**
POSITION MEASURING DEVICE AND METHOD FOR PRODUCING A LIGHT SOURCE FOR A SENSOR UNIT OF A POSITION MEASURING DEVICE
PROCÉDÉ DE FABRICATION D'UNE SOURCE LUMINEUSE POUR UNE UNITÉ DE CAPTEUR DE POSITION D'UN DISPOSITIF DE MESURE DE POSITION AINSI QUE DISPOSITIF DE MESURE DE POSITION

(43) Veröffentlichungstag der Anmeldung: 08.01.2020
(73) Patentinhaber: Dr. Johannes Heidenhain GmbH, 83301 Traunreut (DE)
(72) Erfinder: HUBNER, Tobias, 83342 Tacherting (DE); ANGERER, Roman, 83435 Bad Reichenhall (DE); GÜNTERT, Jürgen, 83278 Traunstein (DE); OBERLECHNER, Florian, 83278 Traunstein (DE); HAUSSCHMID, Mathias, 83349 Palling (DE); GÖHRE, Jens-Martin, 83362 Surberg (DE); STERKEL, Martin, 83209 Prien am Chiemsee (DE)

(56) Entgegenhaltungen:
- DE-A1-102012 107 578
- DE-A1-102013 103 011
- DE-U1-202007 002 582

## Beschreibung

Die Erfindung betrifft ein Verfahren zur Herstellung einer Lichtquelle für eine Sensoreinheit einer Positionsmesseinrichtung gemäß dem Anspruch 1. Ferner betrifft die Erfindung eine Positionsmesseinrichtung gemäß dem Anspruch 12.

### GEBIET DER TECHNIK

Positionsmesseinrichtungen werden beispielsweise als Winkelmesseinrichtungen oder als Drehgeber zur Bestimmung der Winkellage zweier relativ zueinander drehbarer Maschinenteile verwendet. Darüber hinaus sind Längenmesseinrichtungen bekannt, bei denen eine lineare Verschiebung zweier relativ zueinander verschiebbarer Maschinenteile gemessen wird. Winkelmesseinrichtungen wie auch Längenmesseinrichtungen weisen üblicherweise Sensoreinheiten auf, die relativ zu den Sensoreinheiten bewegbare Bauteile, etwa Winkelskalierungen oder Längenskalierungen beziehungsweise Maßstäbe abtasten und positionsabhängige Signale erzeugen.

Bei optischen Messeinrichtungen sind häufig Lichtquellen und Fotodetektoren auf einer Leiterplatte einer optischen Sensoreinheit montiert. Mit einem Luftspalt von der Leiterplatte gegenüber liegend befindet sich eine optische Skalierung. Nach bekannten Prinzipien können dann von der Position abhängige Signale erzeugt werden.

Häufig werden derartige Messeinrichtungen beziehungsweise Messgeräte für elektrische Antriebe, zur Bestimmung der Relativbewegung beziehungsweise der Relativlage von entsprechenden Maschinenteilen, eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der DE 10 2012 107 578 A1 wird ein LED-Chip für optische Positionsmessvorrichtungen beschrieben, der in einem Gehäuse angeordnet ist. Zur Kontaktierung des LED-Chips können an dem Gehäuse lotfähige Kontakte vorgesehen sein, beispielsweise in Form von Drahtanschlüssen oder von Anschlussflächen.

### ZUSAMMENFASSUNG DER ERFINDUNG

Der Erfindung liegt die Aufgabe zugrunde ein Verfahren zur Herstellung einer Lichtquelle für eine Sensoreinheit einer Positionsmesseinrichtung zu schaffen, durch das qualitativ hochwertige Lichtquellen wirtschaftlich herstellbar sind.

Weiterhin wird durch die Erfindung eine Positionsmesseinrichtung geschaffen, durch die eine präzise Positionsmessung zuverlässig möglich ist.

Diese Aufgaben werden erfindungsgemäß durch die Merkmale des Anspruches 1 beziehungsweise durch die Merkmale des Anspruches 12 gelöst. Demnach wird gemäß dem erfindungsgemäßen Verfahren zur Herstellung einer Lichtquelle für eine Sensoreinheit einer Positionsmesseinrichtung zunächst zumindest ein Halbleiter-Bauelement bereitgestellt, das derart beschaffen ist, dass durch dieses Licht bei Einleiten eines elektrischen Stromes emittierbar ist. Dieses Halbleiter-Bauelement wird an einem elektrisch leitfähigen Trägerkörper in einer Weise befestigt und elektrisch kontaktiert, dass eine erste Baugruppe entsteht, welche das zumindest eine Halbleiter-Bauelement und den Trägerkörper umfasst. Nachfolgend wird die erste Baugruppe auf einem ersten Hilfsträger befestigt, so dass eine lichtemittierende erste Seite des zumindest einen Halbleiter-Bauelements dem ersten Hilfsträger zugewandt angeordnet ist. Alternativ kann auch das Halbleiter-Bauelement zunächst auf dem ersten Hilfsträger befestigt werden bevor der elektrisch leitfähige Trägerkörper am zumindest einen Halbleiter-Bauelement befestigt wird. In einem weiteren Verfahrensschritt wird ein elektrisch leitfähiger Körper, der vorzugsweise als ein Metallkörper, insbesondere als ein massiver Metallkörper ausgestaltet sein kann beispielsweise aus einem kupferhaltigem Material, auf dem ersten Hilfsträger befestigt. Nach diesen Schritten, die in unterschiedlichen Reihenfolgen abgearbeitet werden können, ist der elektrisch leitfähige Körper neben dem Trägerkörper angeordnet. Danach wird auf den ersten Hilfsträger eine erste Vergussmasse aufgebracht, so dass der Trägerkörper und der elektrisch leitfähige Körper durch die erste Vergussmasse relativ zueinander fixiert sind. Nachfolgend wird der erste Hilfsträger entfernt. In einem weiteren Verfahrensschritt wird dann ein so genannter Brücken-Leiterzug zwischen dem elektrisch leitfähigen Körper und der ersten Baugruppe hergestellt, so dass diese elektrisch miteinander verbunden sind. Darüber hinaus wir ein erstes Testpad hergestellt, das mit der ersten Baugruppe elektrisch kontaktiert ist. Weiterhin wird ein zweites Testpad hergestellt, das mit dem elektrisch leitfähigen Körper elektrisch kontaktiert ist, so dass ein Panel entsteht. Dieses Panel umfasst die erste Baugruppe, die erste Vergussmasse, den Brücken-Leiterzug sowie das erste und das zweite Testpad. Zur Durchführung eines temporären Betriebs, in dem das Halbleiter-Bauelement Licht emittiert, wird dann ein elektrischer Strom über das erste Testpad durch das Halbleiter-Bauelement und über das zweite Testpad geleitet beziehungsweise werden Elektroden, die eine Spannungsdifferenz aufweisen, am ersten Testpad und am zweiten Testpad angelegt. Nachfolgend wird zur Herstellung der Lichtquelle das Panel zertrennt, wobei das erste und / oder das zweite Testpad zumindest teilweise von der Lichtquelle abgetrennt wird.

Die Lichtquellen können zusätzlich auch jeweils einen oder mehrere Regelungsschaltungsbausteine aufweisen. Derartige Regelungsschaltungsbausteine sind beispielsweise LED-Treiber oder Treiber-ICs. Demnach wird ein derartiger Regelungsschaltungsbaustein mit vergossen, insbesondere kann der Regelungsschaltungsbaustein im Zuge des Herstellungsverfahrens auf dem ersten Hilfsträger befestigt werden.

Als Halbleiter-Bauelement kommt insbesondere eine LED in Betracht oder eine Laserdiode, eine Resonant-Cavity Light Emitting Diode (RCLED bzw. RC-LED), ein Vertical-Cavity Surface-Emitting Laser (VCSEL) oder eine organische Leuchtdiode (OLED).

Im Folgenden kann unter dem Begriff Leiterzug eine Leiterbahn verstanden werden, die entweder auf einer Ebene verläuft oder im dreidimensionalen Raum. Insbesondere kann daher der Leiterzug auch eine Leiterbahn mit einer Durchkontaktierung beziehungsweise mit einem Via sein. Ein Leiterzug kann als eine Schicht ausgestaltet sein oder mehrere Schichten umfassen.

Mit Vorteil ist der Brücken-Leiterzug mit dem Trägerkörper elektrisch kontaktiert insbesondere unmittelbar mit diesem verbunden.

In vorteilhafter Weise wird zumindest ein erster Leiterzug hergestellt, welcher mit dem Halbleiter-Bauelement elektrisch kontaktiert ist und ein Anschlusspad aufweist.

In weiterer Ausgestaltung der Erfindung ist der Brücken-Leiterzug mit der ersten Seite des zumindest einen Halbleiter-Bauelements elektrisch kontaktiert. In diesem Fall kann optional zumindest ein erster Leiterzug hergestellt werden, welcher mit dem Trägerkörper elektrisch kontaktiert ist und ein Anschlusspad aufweist.

In weiterer Ausgestaltung der Erfindung wird zumindest ein zweiter Leiterzug hergestellt, welcher mit dem elektrisch leitfähigen Körper elektrisch kontaktiert ist und ein Anschlusspad aufweist.

Insbesondere kann auf einem Panel, das mehrere Lichtquellen aufweist, für jede der Lichtquellen ein eigenes Anschlusspad hergestellt werden. Ein Panel kann eine rechteckige Außenkontur aufweisen, aber auch als Vieleck oder als Scheibe ausgebildet sein, wobei scheibenförmige Panels auch als Wafer bezeichnet werden. Insbesondere ist das Panel als ebener Körper ausgestaltet.

In weiterer Ausgestaltung der Erfindung wird der Brücken-Leiterzug mit der ersten Seite des zumindest einen Halbleiter-Bauelements elektrisch kontaktiert.

Ein Anschlusspad dient zur dauerhaften Kontaktierung der Lichtquelle im Betrieb der Positionsmesseinrichtung. Dagegen dienen die Testpads zur vorübergehenden elektrischen Kontaktierung zur Durchführung des temporären Betriebs, in dem das Halbleiter-Bauelement Licht emittiert.

Die elektrischen Kontaktierungen des Halbleiter-Bauelements erfolgen ohne die Verwendung von Drähten oder dergleichen. Insbesondere kann auf ein Wire-Bonding beziehungsweise auf ein Drahtbonden verzichtet werden.

In vorteilhafter Weise werden der Trägerkörper und der elektrisch leitfähige Körper nach dem Aufbringen der ersten Vergussmasse einem Schleifprozess unterzogen zur Herstellung einer der ersten Seite der Halbleiter-Bauelemente gegenüber liegenden, insbesondere planen, Oberfläche.

Mit Vorteil wird das Zertrennen mit Hilfe eines Trennschleifprozesses vorgenommen. Alternativ kann auch ein Laserschneidprozess oder ein Wasserstrahlschneidprozess angewendet werden. Insbesondere können dabei auch der erste Leiterzug und / oder der zweite Leiterzug zertrennt werden. Mit Vorteil wird das Zertrennen so vorgenommen, dass das oder die Testpads vom Halbleiter-Bauelement abgetrennt wird beziehungsweise werden.

Nach dem Einleiten oder während des Einleitens eines elektrischen Stromes zur Durchführung des temporären Betriebs und vor dem Zertrennen des Trägerkörpers können defekte Lichtquellen vorteilhafterweise markiert werden.

Vorteilhaft werden auf dem ersten Hilfsträger mehrere erste Baugruppen befestigt, so dass jeweils die erste Seite der Halbleiter-Bauelemente dem ersten Hilfsträger zugewandt angeordnet sind, wobei das Panel mehrere erste Baugruppen umfasst.

Insbesondere können dann auf dem ersten Hilfsträger mehrere elektrisch leitfähige Körper befestigt werden, jeweils neben einem Trägerkörper, wobei dann das Panel mehrere elektrisch leitfähige Körper umfasst.

Mit Vorteil ist das Panel so ausgestaltet, dass der erste Leiterzug und der zweite Leiterzug auf der gleichen Seite des Panels angeordnet sind.

In weiterer Ausgestaltung der Erfindung weist das Panel mehrere Halbleiter-Bauelemente auf. Dabei sind die Halbleiter-Bauelemente elektrisch gemäß einer Reihenschaltung verbunden, so dass zur Durchführung des temporären Betriebs der elektrische Strom über das erste Testpad durch die mehreren Halbleiter-Bauelemente und insbesondere über mehrere Brücken-Leiterzüge zum zweiten Testpad geleitet wird.

Gemäß einem weiteren Aspekt umfasst die Erfindung eine Positionsmesseinrichtung, die eine Sensoreinheit und ein relativ zur Sensoreinheit bewegbares Bauteil mit einer Skalierung aufweist. Die Sensoreinheit umfasst eine Lichtquelle, die nach dem erfindungsgemäßen Verfahren hergestellt ist und einen Fotodetektor.

Mit Vorteil weist der Fotodetektor eine fotoempfindliche Fläche auf, wobei die lichtemittierende erste Seite des Halbleiter-Bauelements und die fotoempfindliche Fläche an derselben Seite der Sensoreinheit angeordnet sind.

In Weiterbildung der Positionsmesseinrichtung ist das Bauteil relativ zur Sensoreinheit drehbar und die Skalierung ist als eine Winkelskalierung ausgestaltet.

Alternativ kann die Positionsmesseinrichtung derart aufgebaut sein, dass das Bauteil relativ zur Sensoreinheit linear verschiebbar ist und die Skalierung als eine Längenskalierung ausgestaltet ist.

Die Skalierung kann also als Winkel- oder Längenskalierung ausgestaltet sein und zu einer inkrementalen oder absoluten Positionsmessung eingerichtet sein. Unter dem Begriff Skalierung ist ein Körper zu verstehen, der eine inkrementale oder absolute Teilung aufweist und häufig auch als Maßverkörperung bezeichnet wird.

Vorteilhafte Ausbildungen der Erfindung entnimmt man den abhängigen Ansprüchen.

Weitere Einzelheiten und Vorteile des erfindungsgemäßen Verfahrens beziehungsweise der Positionsmesseinrichtung ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1: eine Schnittdarstellung einer ersten Baugruppe, die ein Halbleiter-Bauelement und einen Trägerkörper umfasst in einer ersten Herstellungsphase einer Lichtquelle,
- Figur 2: eine Schnittdarstellung der ersten Baugruppe in einer weiteren Herstellungsphase der Lichtquelle,
- Figur 3: eine Schnittdarstellung der ersten Baugruppe in einer darauffolgenden Herstellungsphase der Lichtquelle,
- Figur 4: eine Schnittdarstellung der ersten Baugruppe mit Leiterzügen in einer späteren Herstellungsphase der Lichtquelle,
- Figur 5: eine Schnittdarstellung der ersten Baugruppe mit Leiterzügen in einer darauffolgenden Herstellungsphase der Lichtquelle,
- Figur 6: eine Draufsicht auf ein Panel mit mehreren Lichtquellen,
- Figur 7: eine Schnittdarstellung eines Teilbereichs der Sensoreinheit nach einem Herstellungsschritt,
- Figur 8: eine Schnittdarstellung eines Teilbereichs der Sensoreinheit nach einem späteren Herstellungsschritt,
- Figur 9: eine Schnittdarstellung eines Teilbereichs der Sensoreinheit nach einem späteren Herstellungsschritt,
- Figur 10: eine Seitenansicht auf eine Positionsmesseinrichtung,
- Figur 11: eine Draufsicht auf ein Panel mit mehreren Lichtquellen, gemäß einem zweiten Ausführungsbeispiel,
- Figur 12: eine Schnittdarstellung der ersten Baugruppe mit Leiterzügen, gemäß dem zweiten Ausführungsbeispiel,
- Figur 13: eine Schnittdarstellung eines Teilbereichs der Sensoreinheit nach einem späteren Herstellungsschritt, gemäß dem zweiten Ausführungsbeispiel.

### BESCHREIBUNG DER AUSFÜHRUNGSFORMEN

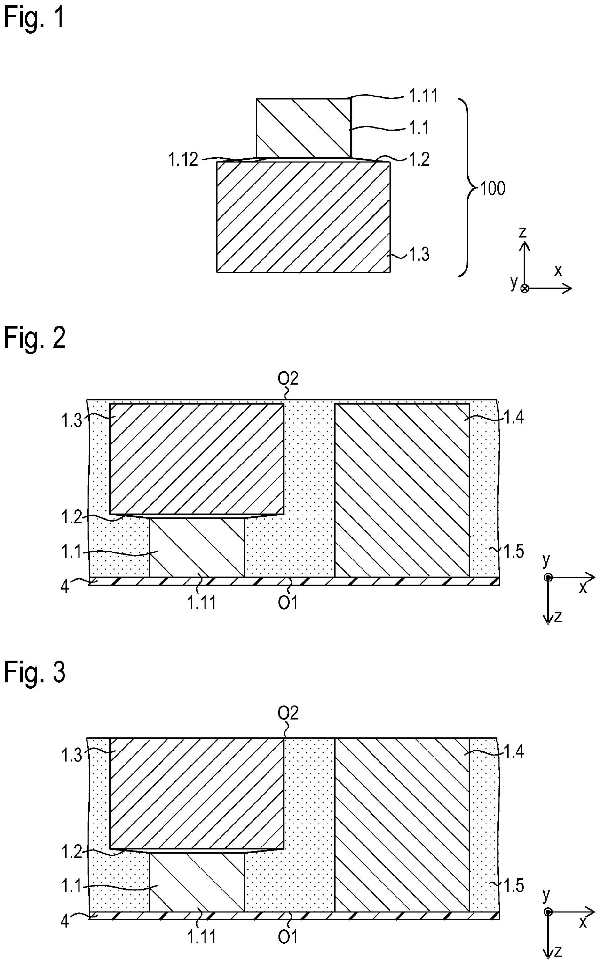

Gemäß einem ersten Ausführungsbeispiel werden zunächst Halbleiter-Bauelemente 1.1 bereitgestellt, wobei beispielsweise in der Figur 1 ein solches Halbleiter-Bauelement 1.1 dargestellt ist. Als Halbleiter-Bauelemente 1.1 kommen etwa LEDs beziehungsweise Halbleiterkristalle in Betracht. Die Halbleiter-Bauelemente 1.1 haben die Eigenschaft, dass durch diese bei Anlegen einer elektrischen Spannungsdifferenz Licht emittierbar ist. Die Halbleiter-Bauelemente 1.1 weisen jeweils eine erste Schicht beziehungsweise Seite 1.11 auf, welche im Betrieb Licht abstrahlt und welche hier ein p-dotiertes Halbleitermaterial umfasst. Zudem umfassen die Halbleiter-Bauelemente 1.1 jeweils eine zweite Schicht 1.12, die im vorgestellten Ausführungsbeispiel n-dotiertes Halbleitermaterial aufweist. Bezüglich des Schichtaufbaues können das p-dotierte Halbleitermaterial und das n-dotierte Halbleitermaterial auch vertauscht angeordnet sein.

Weiterhin wird ein Trägerkörper 1.3 (siehe Figur 1) bereitgestellt, der hier quaderförmig ausgestaltet ist. Im vorgestellten Ausführungsbeispiel ist der Trägerkörper 1.3 aus Metall, insbesondere aus einem Kupferwerkstoff. Die Breite des Trägerkörpers 1.3 in x-Richtung beträgt in diesem Beispiel 0,6 mm, seine Länge in y-Richtung 0,7 mm und seine Dicke in z-Richtung 0,5 mm.

Auf diesen Trägerkörper 1.3 wird ein elektrisch leitender Kleber 1.2, beispielsweise ein mit Silber-Partikeln gefülltes Epoxid-Material, aufgetragen.

Auf den Kleber 1.2 wird ein Halbleiter-Bauelement 1.1 platziert. Im vorgestellten Ausführungsbeispiel wird die n-dotierte zweite Seite 1.12 des Halbleiter-Bauelements 1.1 mit dem Trägerkörper 1.3 durch den Kleber 1.2 elektrisch kontaktiert. Auf diese Weise ist das Halbleiter-Bauelement 1.1 am Trägerkörper 1.3 befestigt und elektrisch kontaktiert. Eine Einheit aus dem Halbleiter-Bauelement 1.1 und dem Trägerkörper 1.3 mit Kleber 1.2 wird im vorgestellten Ausführungsbeispiel als erste Baugruppe 100 bezeichnet.

Auf die beschriebene Weise werden eine Vielzahl von derartigen ersten Baugruppen 100 hergestellt und gemäß der Figur 2 auf einen ersten Hilfsträger 4, der im vorgestellten Ausführungsbeispiel als eine Klebefolie ausgestaltet ist, befestigt, insbesondere aufgeklebt. Die ersten Baugruppen 100 sind danach so angeordnet, dass jeweils die erste Seite 1.11 der Halbleiter-Bauelemente 1.1 dem ersten Hilfsträger 4 zugewandt ist.

Ebenso werden auf dem ersten Hilfsträger 4 elektrisch leitfähige Körper 1.4 befestigt, insbesondere aufgeklebt. Im vorgestellten Ausführungsbeispiel ist jeder Körper 1.4 als ein Metallquader, insbesondere aus einem Kupfermaterial, hergestellt. Die Körper 1.4 werden so auf dem ersten Hilfsträger 4 platziert, dass diese jeweils neben dem Trägerkörper 1.3 mit einem Versatz in x-Richtung angeordnet sind.

Neben dieser Anordnung werden außerdem weitere Paare, die jeweils eine erste Baugruppe 100 aus Halbleiter-Bauelementen 1.1 und einen Trägerkörper 1.3 sowie den Körpern 1.4 umfassen, mit Versatz zueinander in x-Richtung auf dem ersten Hilfsträger 4 aufgeklebt. Zudem befinden sich weitere derartiger Paare in y-Richtung versetzt auf dem ersten Hilfsträger 4.

Im nächsten Herstellungsschritt wird eine erste Vergussmasse 1.5 (Figur 2) auf den ersten Hilfsträger 4 aufgebracht, so dass das Volumen um die Halbleiter-Bauelemente 1.1 und den Körper 1.4 zumindest teilweise mit der ersten Vergussmasse 1.5 ausgefüllt ist. Es kann beispielsweise ein Dispenser oder eine Vergussanlage beziehungsweise eine Moldingeinrichtung verwendet werden um die erste Vergussmasse 1.5 aufzutragen. Nach dem Aushärten der ersten Vergussmasse 1.5 sind die Trägerkörper 1.3 und die elektrisch leitfähigen Körper 1.4 relativ zueinander fixiert. Im vorgestellten Ausführungsbeispiel kann durch die Fixierung beziehungsweise Klebung der Halbleiter-Bauelemente 1.1 und der Körper 1.4 in Verbindung mit einem schonenden Vergussverfahren sichergestellt werden, dass keine Verschiebung der Halbleiter-Bauelemente 1.1 und der Körper 1.4 während des Aufbringens der ersten Vergussmasse 1.5 auftritt.

Nach dem Vergießen und Aushärten der ersten Vergussmasse 1.5, die beispielsweise als ein Epoxid-Material mit Füllstoffen ausgestaltet sein kann, sind also die vergossenen Elemente durch die erste Vergussmasse 1.5 relativ zueinander fixiert. Auf diese Weise wurde ein Panel P erzeugt, das eine erste Oberfläche O1 aufweist, welches in dieser Herstellungsphase vom Hilfsträger 4 abgedeckt ist, und das eine zweite Oberfläche O2 aufweist, die der ersten Oberfläche O1 (bezogen auf die z-Richtung) gegenüber liegend angeordnet ist.

Als nächstes wird die zweite Oberfläche O2 plan geschliffen also einem Schleifprozess unterzogen, so dass neben der ersten Vergussmasse 1.5 die Trägerkörper 1.3 und die elektrisch leitfähigen Körper 1.4 gemäß der Figur 3 bis zur Oberfläche O2 reichen und bündig zueinander angeordnet sind. Auf diese Weise wird die der ersten Seite 1.11 der Halbleiter-Bauelemente 1.1 gegenüber liegenden Oberfläche O2 hergestellt.

In einem darauffolgenden Schritt wird die jeweilige geschliffene Oberfläche O2 des Trägerkörpers 1.3 und der elektrisch leitfähigen Körper 1.4 gereinigt und für eine gute Kontaktierbarkeit vorbereitet beziehungsweise vorbehandelt.

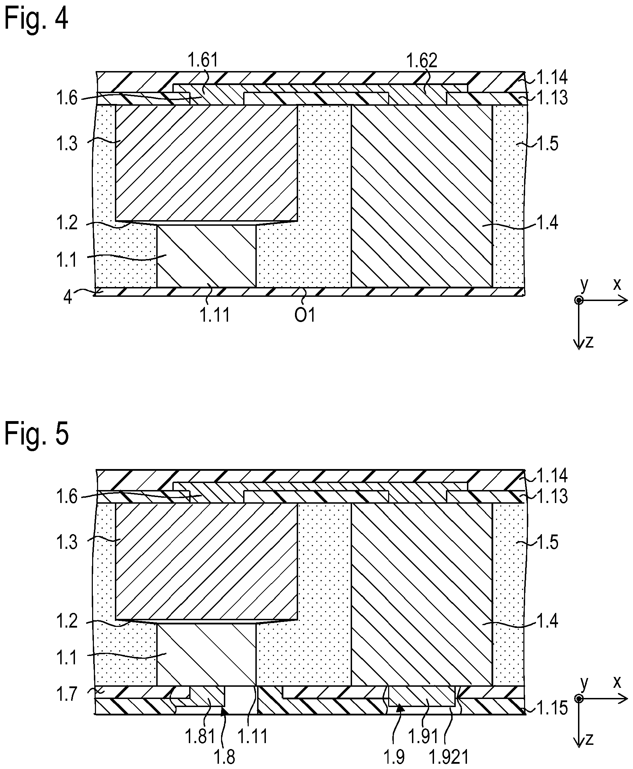

Darauffolgend wird eine isolierende erste Schicht 1.13, insbesondere eine Schicht aus Polyimid, auf die zweite Oberfläche O2, also auf die erste Vergussmasse 1.5, auf die Trägerkörper 1.3 sowie auf die elektrisch leitfähigen Körper 1.4 aufgetragen beziehungsweise auflaminiert (siehe die Figur 4). Diese erste Schicht 1.13 wird unter Verwendung eines fotochemischen Verfahrens so strukturiert, dass Durchgangsöffnungen für einen später herzustellenden Brücken-Leiterzug 1.6 vorliegen. Im Anschluss daran wird gemäß der Figur 4 auf die erste Schicht 1.13 der Brücken-Leiterzug 1.6 aufgebracht, welchen danach eine elektrisch isolierende erste Passivierungsschicht 1.14 aufgebracht wird. Unter bestimmten Voraussetzungen kann auch auf die erste Schicht 1.13 verzichtet werden.

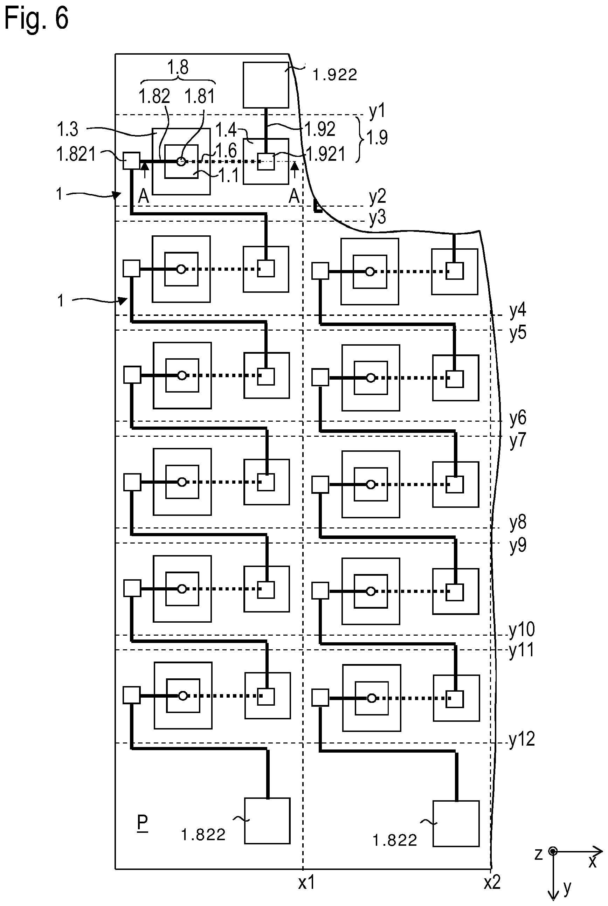

Im Ergebnis liegt dann jeweils ein Brücken-Leiterzug 1.6 vor, der jeweils einen ersten Abschnitt 1.61 und einen zweiten Abschnitt 1.62 aufweist (in der Figur 6 ist eine entsprechende Draufsicht auf das Panel P gezeigt). In seinem ersten Abschnitt 1.61 ist der Brücken-Leiterzug 1.6 durch die erste Schicht 1.13 hindurch geführt, insbesondere durch die Durchgangsöffnungen. Außerdem wird im ersten Abschnitt 1.61, wie auch in der Figur 4 ersichtlich, ein elektrischer Kontakt zwischen dem Brücken-Leiterzug 1.6 und dem zugehörigen Trägerkörper 1.3 hergestellt. Im zweiten Abschnitt 1.62 ist der der Brücken-Leiterzug 1.6 ebenfalls durch die erste Schicht 1.13 hindurch geführt, so dass ein elektrischer Kontakt zwischen dem Brücken-Leiterzug 1.6 und dem elektrisch leitfähigen Körper 1.4 hergestellt ist.

Diese Brücken-Leiterzüge 1.6 werden so bearbeitet beziehungsweise strukturiert, dass letztlich für jedes der Halbleiter-Bauelemente 1.1 jeweils ein Brücken-Leiterzug 1.6 als ein elektrischer Kontakt zwischen dem elektrisch leitfähigen Körper 1.4 und dem Trägerkörper 1.3 hergestellt ist. Folglich sind die betreffenden Brücken-Leiterzüge 1.6 beziehungsweise Kontakte in y-Richtung voneinander beabstandet. Im vorgestellten ersten Ausführungsbeispiel ist jeweils der Brücken-Leiterzug 1.6 mit der Rückseite des Trägerkörpers 1.3 kontaktiert, also mit derjenigen Seite des Trägerkörpers 1.3, die dem Halbleiter-Bauelement 1.1 angewandt ist.

In einem nachfolgenden Schritt der Herstellung wird der erste Hilfsträger 4 entfernt. Somit ist jeweils die erste Seite 1.11 der Halbleiter-Bauelemente 1.1 bündig mit der ersten Oberfläche O1 (Figur 3) der ersten Vergussmasse 1.5 angeordnet. Darauffolgend werden die nun freigelegten Oberflächen der Halbleiter-Bauelemente 1.1 und der elektrisch leitfähigen Körper 1.4 gereinigt.

Danach wird auf die erste Oberfläche O1, also auf die erste Vergussmasse 1.5, auf die erste Schicht 1.11 der Halbleiter-Bauelemente 1.1 sowie auf den elektrisch leitfähigen Körper 1.4 eine zweite isolierende Schicht 1.7, beispielsweise eine Polyimid-Schicht, aufgebracht beziehungsweise auflaminiert (siehe die Figur 5). Diese zweite isolierende Schicht 1.7 wird unter Verwendung eines fotochemischen Verfahrens so strukturiert, dass Durchgangsöffnungen für später herzustellende erste Leiterzüge 1.8 und zweite Leiterzüge 1.9 vorliegen und für eine gute Kontaktierbarkeit vorbereitet beziehungsweise vorbehandelt. Im Anschluss daran werden gemäß der Figur 5 auf die zweite isolierende Schicht 1.7 die ersten Leiterzüge 1.8 und die zweiten Leiterzüge 1.9 aufgebracht. Diese Leiterzüge 1.8, 1.9 werden so bearbeitet beziehungsweise strukturiert, dass letztlich Anschlussleiter gemäß der Figur 5 durch einen selektiven Leiterzugaufbau erzeugt werden. Auf den ersten und auf den zweiten Leiterzug 1.8, 1.9 wird eine elektrisch isolierende erste Passivierungsschicht 1.15 aufgebracht.

Im Ergebnis liegt dann jeweils ein erster Leiterzug 1.8 vor, der jeweils einen ersten Abschnitt 1.81 und einen zweiten Abschnitt 1.82 aufweist (in der Figur 6 ist eine entsprechende Draufsicht auf das Panel P gezeigt). In seinem ersten Abschnitt 1.81 ist der erste Leiterzug 1.8 durch die erste Schicht 1.7 hindurch geführt, insbesondere durch die Durchgangsöffnungen. Außerdem wird im ersten Abschnitt 1.81, wie auch in der Figur 5 ersichtlich, ein elektrischer Kontakt zwischen dem ersten Leiterzug 1.8 und dem Halbleiter-Bauelement 1.1 hergestellt.

Jeder zweite Abschnitt 1.82 der ersten Leiterzüge 1.8 umfasst ein so genanntes Anschlusspad 1.821. Weiterhin verlaufen die ersten Leiterzüge 1.8 im zweiten Abschnitt 1.82 auf der ersten Schicht 1.7 parallel zur zweiten Oberfläche O2 und sind von dieser entsprechend der Dicke der ersten Schicht 1.7 beabstandet.

Zudem werden die zweiten Leiterzüge 1.9 analog zur Erzeugung der ersten Leiterzüge 1.8 hergestellt. Dazu wird die erste Passivierungsschicht 1.15 zunächst fotolithografisch geöffnet und ein metal finish aufgebracht. Die zweiten Leiterzüge 1.9 weisen demnach auch einen ersten Abschnitt 1.91 und einen zweiten Abschnitt 1.92 auf und jeweils ein Anschlusspad 1.921, so dass ein elektrischer Kontakt zwischen dem Anschlusspad 1.91 und dem elektrisch leitfähigen Körper 1.4 hergestellt ist.

Somit ist eine Anordnung hergestellt, wie sie in der Figur 5 dargestellt ist. Die Figur 5 ist eine Schnittansicht durch die Linie A - A in der Figur 6, wobei diese die Anordnung gemäß der Figur 5 in einer Ansicht von unten zeigt.

Außerdem werden jeweils erste Testpads 1.822 und zweite Testpads 1.922 erzeugt, die mit den ersten Leiterzügen 1.8 beziehungsweise mit den zweiten Leiterzügen 1.9 elektrisch verbunden sind.

Auf die oben beschriebene Weise wurde ein Panel P erzeugt, das gemäß der Figur 6 unter anderem eine Vielzahl von Lichtquellen 1 und entsprechend auch mehrere elektrisch leitfähige Körper 1.4 aufweist. In der Figur 6 sind der Übersichtlichkeit halber im Wesentlichen nur die Elemente einer der Lichtquellen 1 nämlich derjenigen, die in der Figur 6 links oben dargestellt ist, mit Bezugszeichen versehen. Grundsätzlich sind alle Lichtquellen 1 gleich aufgebaut und weisen demnach jeweils die gleichen Elemente auf.

Außer den in den Figuren gezeigten Elementen einer Lichtquelle 1 kann zusätzlich auch jeweils eine Regelungsschaltung in den Lichtquellen 1 integriert werden. Derartige Regelungsschaltungen sind beispielsweise LED-Treiber oder Treiber-ICs.

Zur Sicherstellung der Zuverlässigkeit jeder einzelnen Lichtquelle 1 wird nun an jedes erste Testpad 1.822 und an jedes zweite Testpad 1.922 je eine Elektrode angelegt, so dass eine elektrische Spannungsdifferenz zwischen diesen vorliegt. Die ersten Testpads 1.822 sind jeweils mit einem Halbleiter-Bauelement 1.1 verbunden und die zweiten Testpads 1.922 sind mit einem elektrisch leitfähigen Körper 1.4 verbunden. Auf der anderen in der Figur 6 nicht sichtbaren Seite des Panels P befinden sich die Brücken-Leiterzüge 1.6, die in der Figur 6 gestrichelt dargestellt sind.

Entsprechend fließt, verursacht durch die Spannungsdifferenz, ein elektrischer Strom, der über das erste Testpad 1.822 und das zweite Testpad 1.922 eingeleitet wurde über die in Serie geschalteten Halbleiter-Bauelemente 1.1, Trägerkörper 1.3 und Brücken-Leiterzüge 1.6 sowie die elektrisch leitfähigen Körper 1.4.

Die Halbleiter-Bauelemente 1.1 emittieren im stromdurchflossenen Zustand, also im Testbetrieb, Licht. So wird ein temporärer Betrieb durchgeführt, in dem die Lichtquellen 1, beispielsweise eine Woche lang, bestromt werden. Häufig findet dieser Betrieb bei erhöhten Temperaturen in einem Klimaschrank statt. Am Ende des temporären Betriebs wird überprüft welche Halbleiter-Bauelemente 1.1 nicht ordnungsgemäß arbeiten, also kein oder zu wenig Licht emittieren und die betreffenden defekten Lichtquellen 1 werden entsprechend markiert.

Im Anschluss daran werden die Lichtquellen 1 vereinzelt. Zu diesem Zweck wird das Panel P, insbesondere die erste Vergussmasse 1.5 zertrennt. Im vorgestellten Ausführungsbeispiel werden mit Hilfe eines Trennschleiferfahrens mehrere zum Teil parallele Schnitte durchgeführt, die entlang der y-Richtung und der x-Richtung verlaufen. In der Figur 6 sind die Schnitte anhand der gestrichelten Linien x1, x2 und y1 bis y12 dargestellt. Die Bereiche zwischen den Linien y2 und y3 sind Abfall ebenso die Bereiche zwischen den Linien y4 und y5, y6 und y7, y8 und y9, y10 und y11. Desgleichen sind die Bereiche oberhalb der Linie y1 und unterhalb der Linie y 12 in der Figur 6 Abfall. Somit sind diejenigen Bereiche des Panels P, auf denen die ersten Testpads 1.822 und die zweiten Testpads 1.922 angeordnet sind nicht Bestandteil der Lichtquellen 1.

Defekte Lichtquellen 1, die nach dem temporären Betrieb nicht hinreichend funktionsfähig sind, werden ausgesondert.

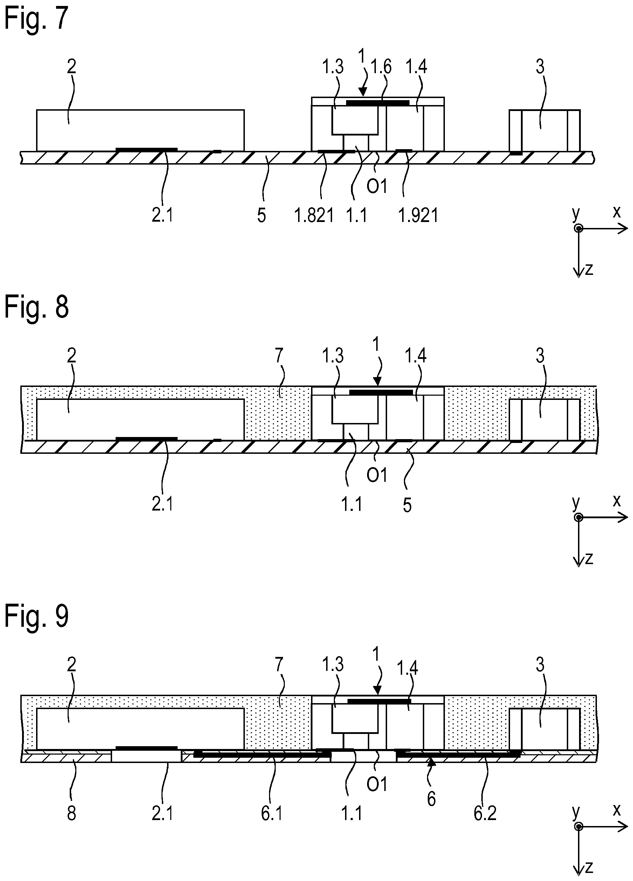

Zur Herstellung einer Sensoreinheit für ein Positionsmessgerät wird nachfolgend die Lichtquelle 1, ein elektronisches Bauelement 2 und beispielsweise ein elektronischer Baustein 3, etwa ein Widerstand, gemäß der Figur 7 auf einem zweiten Hilfsträger 5 platziert. Der zweite Hilfsträger 5 ist wie der erste Hilfsträger 4 als eine Klebefolie ausgestaltet. Das elektronische Bauelement 2, welches hier als IC-Chip ausgestaltet ist, umfasst Fotodetektoren 2.1 beziehungsweise ein oder mehrere Fotodetektorarrays, die Lichtsignale in elektrische Signale umwandeln. Weiterhin umfasst das elektronische Bauelement 2 Schaltungen zur Umwandlung dieser elektrischen Signale, insbesondere zur Digitalisierung der Signale und zu deren digitalen Weiterverarbeitung.

In einem darauffolgenden Schritt wird eine zweite Vergussmasse 7 (Figur 8) auf den zweiten Hilfsträger 5 aufgebracht, so dass das Volumen um das elektronische Bauelement 2, die Lichtquelle 1 und der elektronische Baustein 3 mit der zweiten Vergussmasse 7 ausgefüllt ist. Auch in diesem Prozessschritt kann beispielsweise ein Dispenser oder eine Vergussanlage beziehungsweise eine Moldingeinrichtung verwendet werden um die zweite Vergussmasse 7 aufzutragen. Die lichtempfindlichen Oberflächen der Fotodetektoren 2.1 sind nicht von der zweiten Vergussmasse 7 umgeben. Durch die ausgehärtete zweite Vergussmasse 7 sind unter anderem die Lichtquelle 1 und das elektronische Bauelement 2 relativ zueinander präzise fixiert. Insbesondere sind die lichtempfindlichen Oberflächen der Fotodetektoren 2.1 in z-Richtung bündig mit der lichtemittierenden Oberfläche des Halbleiter-Bauelements 1.1 angeordnet.

Im Anschluss daran wird gemäß der Figur 9 ein weiterer Schichtaufbau vorgenommen, insbesondere wird eine elektrisch leitende Schicht 6 aufgebracht. Diese leitende Schicht 6 wird so bearbeitet beziehungsweise strukturiert, dass letztlich ein dritter Leiterzug 6.1 und ein vierter Leiterzug 6.2 gemäß der Figur 9 durch einen selektiven Leiterzugaufbau erzeugt werden. Der dritte Leiterzug 6.1 ist mit dem Anschlusspad 1.821 des ersten Leiterzugs 1.8 elektrisch verbunden sowie mit einem Kontakt des elektronischen Bauelements 2. Der vierte Leiterzug 6.2 verbindet elektrisch das Anschlusspad 1.921 des zweiten Leiterzugs 1.9 mit einem Kontakt des elektronischen Bausteins 3.

Auf die leitende Schicht 6 beziehungsweise auf den dritten Leiterzug 6.1 und auf den vierten Leiterzug 6.2 wird danach eine elektrisch isolierende zweite Schicht 8 beziehungsweise eine Passivierungsschicht aufgebracht. Optional können auch noch weitere Schichten und weitere Leiterzüge erzeugt werden.

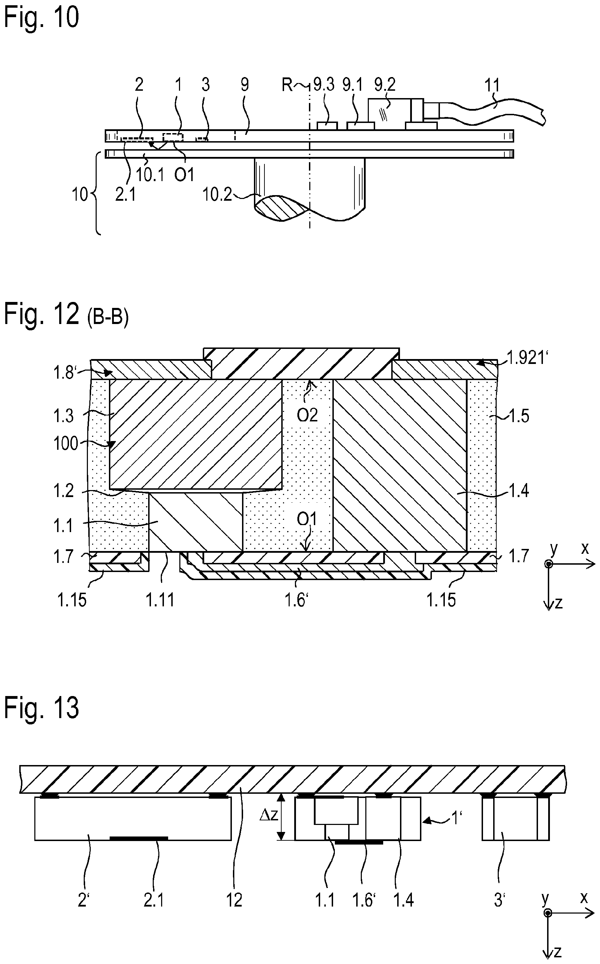

Die so konfigurierte Sensoreinheit gemäß der Figur 9 wird nun in eine Positionsmesseinrichtung eingebaut, insbesondere in einen Drehgeber beziehungsweise in ein Winkelmessgerät gemäß dem Prinzip-Bild der Figur 10. Die Positionsmesseinrichtung umfasst die erfindungsgemäße Sensoreinheit und ein relativ dazu bewegbares (hier relativ zur Sensoreinheit drehbares) Bauteil 10. Das Bauteil 10 besteht aus einer Skalierung 10.1, hier eine Winkelskalierung, und einer Welle 10.2. Im vorgestellten Ausführungsbeispiel umfasst die Skalierung 10.1 zumindest eine umlaufende Teilungs- oder Codespur, die mit einem Auflichtverfahren reflektiv abtastbar ist.

Alternativ kann die Lichtquelle 1 auch im Zusammenhang mit einer Durchlichtanordnung verwendet werden.

Die Sensoreinheit ist in einer im vorgestellten Ausführungsbeispiel im Wesentlichen scheibenförmigen Platte 9 beziehungsweise in einer Ausnehmung der Platte 9 montiert, die beispielsweise an einem Maschinenteil, etwa an einem Motorgehäuse, befestigt werden kann. Die Platte 9 ist hier als starrer Metallkörper beziehungsweise Metallring ausgestaltet. Die Platte 9 weist an zumindest einer Oberfläche eine isolierende Schicht auf, auf der Leiterbahnen und Kontaktierungsflächen hergestellt sind.

Üblicherweise dient das Bauteil 10 beziehungsweise die Winkelskalierung als Rotor und wird an einem um die Drehachse R drehbaren Maschinenteil befestigt. Dagegen bildet dann die Sensoreinheit den Stator der als Winkelmesseinrichtung ausgestalteten Positionsmesseinrichtung, so dass dieser an einem stehenden Maschinenteil fixiert wird. Im zusammengebauten Zustand der Positionsmesseinrichtung stehen sich das Bauteil 10 und die Sensoreinheit mit vergleichsweise geringem Luftspalt einander gegenüber, wobei der Luftspalt kleiner ist als in dem Prinzip-Bild der Figur 10 dargestellt.

Im Betrieb der Positionsmesseinrichtung emittiert die Lichtquelle 1 Licht, das gemäß dem in der Figur 10 angedeuteten Strahlengang von der Teilungsspur der Skalierung 10.1 reflektiert wird und auf die Fotodetektoren 2.1 fällt, die das einfallende Licht in Fotoströme beziehungsweise elektrische Signale umwandeln. Die Drehachse R verläuft durch das Zentrum des Bauteils 10 beziehungsweise der Skalierung 10.1. Bei einer Relativdrehung zwischen dem Bauteil 10 und der Sensoreinheit ist so in den Fotodetektoren 2.1 ein von der jeweiligen Winkelstellung abhängiges Signal erzeugbar.

Durch die oben beschriebene Bauweise der Sensoreinheit kann auf vergleichsweise einfache und kostengünstige Art eine Anordnung geschaffen werden, die eine genaue Einstellung des Spaltes zwischen den Fotodetektoren 2.1 und der Skalierung 10.1 beziehungsweise zwischen der Lichtquelle 1 und der Skalierung 10.1 erlaubt. Insbesondere ist bauartbedingt sichergestellt, dass die der Skalierung 10.1 zugewandte Oberfläche des elektronischen Bauelements 2 bündig mit der ersten Oberfläche O1 angeordnet ist. Durch die exakte Positionierung des elektronischen Bauelements 2 relativ zur Lichtquelle 1 kann nach erfolgter Montage beziehungsweise Fixierung der Lichtquelle 1 an einem Maschinenteil gewährleistet werden, dass das elektronische Bauelement 2, insbesondere die Fotodetektoren 2.1 und die Lichtquelle 1 präzise platziert sind.

Der auf der Platte 9 montierte Baustein 9.1 (beziehungsweise auf einer Kontaktierungsfläche) arbeitet als Auswerteelement für die Signale. In logischen Schaltungen auf dem Digitalteil des Bausteins 9.1 werden die Positionswerte resultierend aus der Abtastung der einzelnen Teilungsspuren ermittelt, beziehungsweise berechnet. Die Positionswerte können über das Kabel 11 an eine Folgeelektronik, beispielsweise eine Numerische Steuerung einer Maschine, übertragen werden. Eine mit der Sensoreinheit ausgestattete Positions- beziehungsweise Winkelmesseinrichtung dient demnach zur Erfassung einer Winkelposition zwischen der Sensoreinheit, die an einem Maschinenteil festlegbar ist und dem Bauteil 10 mit der Skalierung 10.1.

Auf der Platte 9 werden zudem beispielsweise ein Kabelanschluss 9.2 (hier ein Steckverbinder) und weitere elektronische Bauteile 9.3 rückseitig also auf der zweiten Fläche montiert. Demnach sind die weiteren elektronischen Bauteile 9.3 und der Kabelanschluss 9.2 auf einer zweiten Fläche der Platte 9 angeordnet, die der ersten Oberfläche O1 der Platte 9 gegenüber liegt.

Die Sensoreinheit gemäß der Anordnung in Figur 10 kann nun beispielsweise rückseitig mit elektrisch isolierendem Material umspritzt werden, so dass die in der Figur 10 oben liegende Fläche der Platte 9, die elektronischen Bauteile 9.1, 9.2 sowie der Kabelanschluss 9.2 zum Anschluss des Kabels 11 vor äußeren Einflüssen geschützt sind. Die Umspritzung kann in diesem Fall auch gleichzeitig als Zugentlastung für das Kabel 11 dienen.

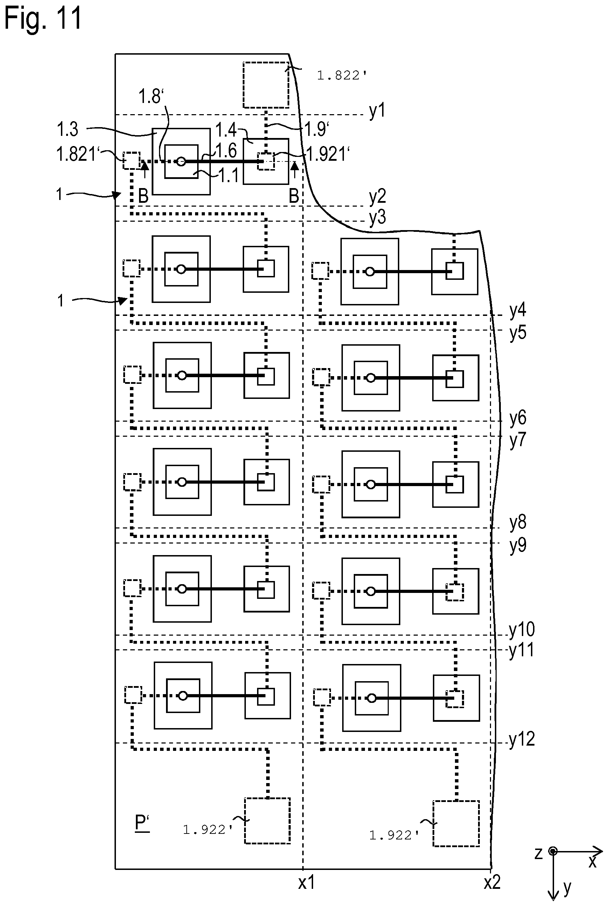

Mit Hilfe der Figuren 11, 12 und 13 wird ein zweites Ausführungsbeispiel vorgestellt. Dieses unterscheidet sich im Wesentlichen von den vorher beschriebenen Ausführungsbeispielen durch die Anordnung des ersten Leiterzuges 1.8', des zweiten Leiterzuges 1.9' und des Brücken-Leiterzuges 1.6'. Im vorgestellten zweiten Ausführungsbeispiel ist insbesondere der Brücken-Leiterzug 1.6' an der Vorderseite des Halbleiter-Bauelements 1.1 kontaktiert.

Zunächst werden gemäß dem zweiten Ausführungsbeispiel auf die Trägerkörper 1.3 jeweils ein Halbleiter-Bauelement 1.1 befestigt und elektrisch kontaktiert analog zur Kontaktierung gemäß dem ersten Ausführungsbeispiel. Die darauffolgenden Herstellungsschritte im Rahmen des zweiten Ausführungsbeispiels entsprechen im Wesentlichen denjenigen des ersten Ausführungsbeispiels (siehe auch die Figuren 1 bis 3 die auch auf das zweite Ausführungsbeispiel zutreffen). Demnach wird auf die erste Oberfläche O1, also auf die erste Vergussmasse 1.5, auf die erste Schicht 1.11 der Halbleiter-Bauelemente 1.1 sowie auf den elektrisch leitfähigen Körper 1.4 eine zweite isolierende Schicht 1.7, beispielsweise eine Polyimid-Schicht aufgebracht beziehungsweise auflaminiert (siehe die Figur 12). Diese zweite isolierende Schicht 1.7 wird unter Verwendung eines fotochemischen Verfahrens so strukturiert, dass Durchgangsöffnungen für später herzustellende Brücken-Leiterzüge 1.6' vorliegen. Im Anschluss daran werden gemäß der Figur 12 auf die zweite isolierende Schicht 1.7 die Brücken-Leiterzüge 1.6' aufgebracht. Diese Brücken-Leiterzüge 1.6' werden so bearbeitet beziehungsweise strukturiert, dass letztlich für jedes der Halbleiter-Bauelemente 1.1 jeweils ein Brücken-Leiterzug 1.6' als eine elektrische Verbindung zum dem elektrisch leitfähigen Körper 1.4 hergestellt ist. Folglich sind die betreffenden Brücken-Leiterzüge 1.6' beziehungsweise Kontakte in y-Richtung voneinander beabstandet. Auf die Brücken-Leiterzüge 1.6' wird eine elektrisch isolierende zweite Passivierungsschicht 1.15 aufgebracht.

Somit ist eine Anordnung hergestellt, wie sie in der Figur 12 dargestellt ist, wobei die Figur 12 eine Schnittansicht durch die Linie B - B in der Figur 11 ist. Das zweite Ausführungsbeispiel unterscheidet sich vom ersten Ausführungsbeispiel insbesondere in der Anordnung der Brücken-Leiterzüge 1.6'. Im ersten Ausführungsbeispiel sind die Brücken-Leiterzüge 1.6 am Trägerkörper 1.3 kontaktiert, während im zweiten Ausführungsbeispiel die Brücken-Leiterzüge 1.6 'an den Halbleiter-Bauelementen 1.1 kontaktiert sind.

Die zweiten Leiterzüge 1.9' werden analog zur Erzeugung der ersten Leiterzüge 1.8' hergestellt. Die zweiten Leiterzüge 1.9' weisen demnach auch einen ersten Abschnitt 1.91' und einen zweiten Abschnitt 1.92' auf und jeweils ein Anschlusspad 1.921', so dass ein elektrischer Kontakt zwischen dem Anschlusspad 1.91' und dem elektrisch leitfähigen Körper 1.4 hergestellt ist. Außerdem weisen die zweiten Leiterzüge 1.9' jeweils ein Testpad 1.922' auf. Die Leiterzüge 1.8', 1.9' werden so bearbeitet beziehungsweise strukturiert, dass letztlich Anschlussleiter gemäß der Figur 12 durch einen selektiven Leiterzugaufbau erzeugt werden.

Die Oberflächen des ersten Testpads 1.822' und des zweiten Testpads 1.922' sind freigelegt und entsprechend elektrisch kontaktierbar.

Außerdem werden jeweils erste Testpads 1.822' und zweite Testpads 1.922' erzeugt, die mit den ersten Leiterzügen 1.8' beziehungsweise mit den zweiten Leiterzügen 1.9' elektrisch verbunden sind.

Wie im ersten Ausführungsbeispiel wird auch im zweiten Ausführungsbeispiel ein Panel P' erzeugt, das gemäß der Figur 11 eine Vielzahl von Lichtquellen 1 aufweist. In der Figur 11 sind der Übersichtlichkeit halber im Wesentlichen nur die Elemente einer Lichtquelle 1 nämlich derjenigen, die in der Figur 11 links oben dargestellt sind, mit Bezugszeichen versehen. Grundsätzlich sind alle Lichtquellen 1 gleich aufgebaut und weisen demnach jeweils die gleichen Elemente auf.

Nun wird an jedem ersten Testpad 1.822' und an jedem zweiten Testpad 1.922' je eine Elektrode zur Einleitung eines elektrischen Stromes angelegt, so dass der elektrische Strom über den Brücken-Leiterzug 1.6' und jeweils über den ersten Leiterzug 1.8' sowie den zweiten Leiterzug 1.9' fließt. Folglich emittieren die Halbleiter-Bauelemente 1.1 in diesem Zustand Licht. So wird ein temporärer Betrieb durchgeführt, in dem die Lichtquellen 1 bestromt werden, insbesondere bei erhöhten Temperaturen. Am Ende des temporären Betriebs wird die Funktionsfähigkeit der einzelnen Halbleiter-Bauelemente 1.1 überprüft.

Im Anschluss daran werden die Lichtquellen 1 vereinzelt. Zu diesem Zweck werden die erste Vergussmasse 1.5 und die ersten Leiterzüge 1.8' sowie die zweiten Leiterzüge 1.9' zertrennt, insbesondere mehrere parallele Schnitte durchgeführt die entlang der y-Richtung und der x-Richtung verlaufen analog zum ersten Ausführungsbeispiel.

Danach wird gemäß der Figur 13 die Lichtquelle 1 an einer Platine 12 kontaktiert beziehungsweise montiert, die bereits mit dem elektronischen Bauelement 2 und dem elektronischen Baustein 3 bestückt ist. Auch durch diese Bauweise gemäß dem zweiten Ausführungsbeispiel kann auf vergleichsweise einfache Weise eine überaus exakte Positionierung der Lichtquelle 1 erreicht werden. Insbesondere kann das für eine präzise arbeitende Positionsmesseinrichtung wichtige Abstandsmaß Δz zwischen der Oberfläche der Lichtquelle 1 und der Oberfläche der Platine 12 exakt eingehalten werden. Durch die beschriebene Bauweise der Sensoreinheit kann auf vergleichsweise einfache und kostengünstige Art eine Anordnung geschaffen werden, die eine genaue Einstellung des Spaltes zwischen den Fotodetektoren 2.1 einer Skalierung beziehungsweise zwischen der Lichtquelle 1 und der Skalierung erlaubt, analog zum ersten Ausführungsbeispiel.

Auch wenn in der Beschreibung Aspekte der Erfindung teilweise anhand der Herstellung von nur einer Lichtquelle 1 beschrieben worden sind umfasst die Erfindung die Herstellung von mehreren Lichtquellen in einem Panel P, P'.

Alternativ zu der Verfahrensweise in den beiden vorgestellten Ausführungsbeispielen, können mehrere Halbleiter-Bauelemente 1.1 auch zunächst auf einen vergleichsweise großen Trägerkörper fixiert werden, der dann im Zuge der weiteren Herstellung beim Schneiden des Panels zertrennt wird. Ebenso können auch im Vergleich größere elektrisch leitfähige Körper verwendet werden, die dann auch mit dem Panel im Zuge des Vereinzelungsschrittes zertrennt werden.

## Patentansprüche

1. Verfahren zur Herstellung einer Lichtquelle (1) für eine Sensoreinheit einer Positionsmesseinrichtung mit folgenden Schritten:
- Bereitstellen zumindest eines Halbleiter-Bauelements (1.1), das derart beschaffen ist, dass durch dieses Licht emittierbar ist,
- Befestigen des Halbleiter-Bauelements (1.1) auf einem ersten Hilfsträger (4), so dass eine erste Seite (1.11) des zumindest einen Halbleiter-Bauelements (1.1) dem ersten Hilfsträger (4) zugewandt angeordnet ist, wobei vor oder nach dem Befestigen des Halbleiter-Bauelements (1.1) auf dem ersten Hilfsträger (4) ein elektrisch leitfähiger Trägerkörper (1.3) am zumindest einen Halbleiter-Bauelement (1.1) befestigt wird, so dass eine erste Baugruppe (100) entsteht, welche das zumindest eine Halbleiter-Bauelement (1.1) und den Trägerkörper (1.3) umfasst,
- Befestigen eines elektrisch leitfähigen Körpers (1.4) auf dem ersten Hilfsträger (4), so dass dieser neben dem Trägerkörper (1.3) angeordnet ist,
- Aufbringen einer ersten Vergussmasse (1.5) auf den ersten Hilfsträger (4), so dass der Trägerkörper (1.3) und der elektrisch leitfähige Körper (1.4) durch die erste Vergussmasse (1.5) relativ zueinander fixiert sind,
- Entfernen des ersten Hilfsträgers (4),
- Herstellen eines Brücken-Leiterzuges (1.6; 1.6') zwischen dem elektrisch leitfähigen Körper (1.4) und der ersten Baugruppe (100),
- Herstellung eines ersten Testpads (1.822; 1.822'), das mit der ersten Baugruppe (100) elektrisch kontaktiert ist,
- Herstellen eines zweiten Testpads (1.922; 1.922'), das mit dem elektrisch leitfähigen Körper (1.4) elektrisch kontaktiert ist, wobei ein Panel (P; P') entsteht, welches die erste Baugruppe (100), die erste Vergussmasse (1.5), den Brücken-Leiterzug (1.6; 1.6') sowie das erste Testpad (1.822; 1.822') und das zweite Testpad (1.922; 1.922') umfasst,
- Leiten eines elektrischen Stromes über das erste Testpad (1.822; 1.822') und das zweite Testpad (1.922; 1.922') zur Durchführung eines temporären Betriebs, in dem das Halbleiter-Bauelement (1.1) Licht emittiert,
- nachfolgendes Zertrennen des Panels (P; P'), wobei das erste und / oder das zweite Testpad (1.822, 1.922; 1.822', 1.922') zumindest teilweise von der Lichtquelle (1) abgetrennt wird.

2. Verfahren gemäß dem Anspruch 1, wobei der Brücken-Leiterzug (1.6) mit dem Trägerkörper (1.3) elektrisch kontaktiert ist.

3. Verfahren gemäß dem Anspruch 2, wobei zumindest ein erster Leiterzug (1.8') hergestellt wird, welcher mit dem Halbleiter-Bauelement (1.1) elektrisch kontaktiert ist und ein Anschlusspad (1.821') aufweist.

4. Verfahren gemäß dem Anspruch 1, wobei der Brücken-Leiterzug (1.6') mit der ersten Seite (1.11) des zumindest einen Halbleiter-Bauelements (1.1) elektrisch kontaktiert ist.

5. Verfahren gemäß dem Anspruch 4, wobei zumindest ein erster Leiterzug (1.8) hergestellt wird, welcher mit dem Trägerkörper (1.3) elektrisch kontaktiert ist und ein Anschlusspad (1.821) aufweist.

6. Verfahren gemäß einem der vorhergehenden Ansprüche, wobei zumindest ein zweiter Leiterzug (1.9; 1.9') hergestellt wird, welcher mit dem elektrisch leitfähigen Körper (1.4) elektrisch kontaktiert ist und ein Anschlusspad (1.921; 1.921') aufweist.

7. Verfahren gemäß einem der vorhergehenden Ansprüche, wobei der Trägerkörper (1.3) und der elektrisch leitfähige Körper (1.4) nach dem Aufbringen der ersten Vergussmasse (1.5) einem Schleifprozess unterzogen werden zur Herstellung einer der ersten Seite (1.11) der Halbleiter-Bauelemente (1.1) gegenüber liegenden Oberfläche (O2).

8. Verfahren gemäß einem der vorhergehenden Ansprüche, wobei das Zertrennen mit Hilfe eines Trennschleifprozesses vorgenommen wird.

9. Verfahren gemäß einem der vorhergehenden Ansprüche, wobei auf dem ersten Hilfsträger (4) mehrere erste Baugruppen (100) befestigt werden, so dass jeweils die erste Seite (1.11) der Halbleiter-Bauelemente (1.1) dem ersten Hilfsträger (4) zugewandt angeordnet sind.

10. Verfahren gemäß dem Anspruch 9, wobei auf dem ersten Hilfsträger (4) mehrere elektrisch leitfähige Körper (1.4) befestigt werden, jeweils neben einem Trägerkörper (1.3), wobei das Panel (P; P') mehrere elektrisch leitfähige Körper (1.4) umfasst.

11. Verfahren gemäß einem der vorhergehenden Ansprüche, wobei der erste Leiterzug (1.8; 1.8') und der zweite Leiterzug (1.9; 1.9') auf der gleichen Seite des Panels (P; P') angeordnet sind.

12. Positionsmesseinrichtung, umfassend eine Sensoreinheit und ein relativ zur Sensoreinheit bewegbares Bauteil (10) mit einer Skalierung (10.1), wobei die Sensoreinheit eine Lichtquelle (1), die nach einem Verfahren gemäß der Ansprüche 1 bis 10 hergestellt ist, und einen Fotodetektor (2) umfasst.

13. Positionsmesseinrichtung gemäß dem Anspruch 12, wobei der Fotodetektor (2) eine fotoempfindliche Fläche (2.1) aufweist, wobei die erste Seite (1.11) des Halbleiter-Bauelements (1.1) und die fotoempfindliche Fläche (2.1) an derselben Seite der Sensoreinheit angeordnet sind.

14. Positionsmesseinrichtung gemäß dem Anspruch 12 oder 13, wobei das Bauteil (10) relativ zur Sensoreinheit drehbar ist und die Skalierung (10.1) als eine Winkelskalierung ausgestaltet ist.

15. Positionsmesseinrichtung gemäß dem Anspruch 12 oder 13, wobei das Bauteil (10) relativ zur Sensoreinheit linear verschiebbar ist und die Skalierung (10.1) als eine Längenskalierung ausgestaltet ist.

## Claims

1. Method for producing a light source (1) for a sensor unit of a position measuring device, comprising the following steps:
- providing at least one semiconductor component (1.1) constituted in such a way that light is emittable by the latter,
- securing the semiconductor component (1.1) on a first auxiliary carrier (4), such that a first side (1.11) of the at least one semiconductor component (1.1) is arranged facing the first auxiliary carrier (4), wherein before or after securing the semiconductor component (1.1) on the first auxiliary carrier (4), an electrically conductive carrier body (1.3) is secured to the at least one semiconductor component (1.1), thus giving rise to a first assembly (100) comprising the at least one semiconductor component (1.1) and the carrier body (1.3),
- securing an electrically conductive body (1.4) on the first auxiliary carrier (4), such that the latter is arranged next to the carrier body (1.3),
- applying a first potting compound (1.5) to the first auxiliary carrier (4), such that the carrier body (1.3) and the electrically conductive body (1.4) are fixed relative to one another by the first potting compound (1.5),
- removing the first auxiliary carrier (4),
- producing a bridge conductor trace (1.6; 1.6') between the electrically conductive body (1.4) and the first assembly (100),
- producing a first test pad (1.822; 1.822'), which is electrically contacted with the first assembly (100),
- producing a second test pad (1.922; 1.992'), which is electrically contacted with the electrically conductive body (1.4), wherein a panel (P; P') arises comprising the first assembly (100), the first potting compound (1.5), the bridge conductor trace (1.6; 1.6') and also the first test pad (1.822; 1.822') and the second test pad (1.922; 1.922'),
- conducting an electric current via the first test pad (1.822; 1.822') and the second test pad (1.922; 1.922') in order to carry out temporary operation in which the semiconductor component (1.1) emits light,
- subsequently dividing the panel (P; P'), wherein the first and/or the second test pad (1.822, 1.922; 1.822', 1.922') are/is at least partly separated from the light source (1).

2. Method according to Claim 1, wherein the bridge conductor trace (1.6) is electrically contacted with the carrier body (1.3).

3. Method according to Claim 2, wherein at least one first conductor trace (1.8') is produced, which is electrically contacted with the semiconductor component (1.1) and has a connection pad (1.821').

4. Method according to Claim 1, wherein the bridge conductor trace (1.6') is electrically contacted with the first side (1.11) of the at least one semiconductor component (1.1).

5. Method according to Claim 4, wherein at least one first conductor trace (1.8) is produced, which is electrically contacted with the carrier body (1.3) and has a connection pad (1.821).

6. Method according to any of the preceding claims, wherein at least one second conductor trace (1.9; 1.9') is produced, which is electrically contacted with the electrically conductive body (1.4) and has a connection pad (1.921; 1.921').

7. Method according to any of the preceding claims, wherein after the first potting compound (1.5) has been applied, the carrier body (1.3) and the electrically conductive body (1.4) are subjected to a grinding process in order to produce a surface (O2) situated opposite the first side (1.11) of the semiconductor components (1.1).

8. Method according to any of the preceding claims, wherein the dividing is carried out with the aid of a separating by grinding process.

9. Method according to any of the preceding claims, wherein a plurality of first assemblies (100) are secured on the first auxiliary carrier (4), such that in each case the first side (1.11) of the semiconductor components (1.1) are arranged facing the first auxiliary carrier (4).

10. Method according to Claim 9, wherein a plurality of electrically conductive bodies (1.4) are secured on the first auxiliary carrier (4), in each case next to a carrier body (1.3), wherein the panel (P; P') comprises a plurality of electrically conductive bodies (1.4).

11. Method according to any of the preceding claims, wherein the first conductor trace (1.8; 1.8') and the second conductor trace (1.9; 1.9') are arranged on the same side of the panel (P; P').

12. Position measuring device, comprising a sensor unit and a component part (10) with a scaling (10.1), said component part being movable relative to the sensor unit, wherein the sensor unit comprises a light source (1) produced according to Claims 1 to 10 and a photodetector (2).

13. Position measuring device according to Claim 12, wherein the photodetector (2) has a photosensitive area (2.1), wherein the first side (1.11) of the semiconductor component (1.1) and the photosensitive area (2.1) are arranged at the same side of the sensor unit.

14. Position measuring device according to Claim 12 or 13, wherein the component part (10) is rotatable relative to the sensor unit and the scaling (10.1) is configured as an angle scaling.

15. Position measuring device according to Claim 12 or 13, wherein the component part (10) is linearly displaceable relative to the sensor unit and the scaling (10.1) is configured as a length scaling.

## Revendications

1. Procédé de fabrication d'une source de lumière (1) pour une unité de capteur d'un dispositif de mesure de position, comprenant les étapes suivantes consistant à :
- fournir au moins un composant semi-conducteur (1.1) qui est tel qu'il peut émettre de la lumière,
- fixer le composant semi-conducteur (1.1) sur un premier support auxiliaire (4) de sorte qu'une première face (1.11) dudit au moins un composant semi-conducteur (1.1) est disposée en étant tournée vers le premier support auxiliaire (4), dans lequel avant ou après la fixation du composant semi-conducteur (1.1) sur le premier support auxiliaire (4), un corps de support électriquement conducteur (1.3) est fixé audit au moins un composant semi-conducteur (1.1) de façon à créer un premier ensemble (100) qui comprend ledit au moins un composant semi-conducteur (1.1) et le corps de support (1.3),
- fixer un corps électriquement conducteur (1.4) sur le premier support auxiliaire (4) de sorte que celui-ci est disposé à côté du corps de support (1.3),
- appliquer une première masse de scellement (1.5) sur le premier support auxiliaire (4) de sorte que le corps de support (1.3) et le corps électriquement conducteur (1.4) sont fixés l'un par rapport à l'autre par la première masse de scellement (1.5),
- retirer le premier support auxiliaire (4),
- fabriquer un tracé conducteur en pont (1.6 ; 1.6') entre le corps électriquement conducteur (1.4) et le premier ensemble (100),
- fabriquer une première plage de test (1.822 ; 1.822') qui est mise en contact électrique avec le premier ensemble (100),
- fabriquer une deuxième plage de test (1.922 ; 1.922') qui est mise en contact électrique avec le corps électriquement conducteur (1.4) constituant un panneau (P ; P') qui comprend le premier ensemble (100), la première masse de scellement (1.5), le tracé conducteur en pont (1.6 ; 1.6') ainsi que la première plage de test (1.822 ; 1.822') et la deuxième plage de test (1.922 ; 1.922'),
- faire passer un courant électrique par la première plage de test (1.822 ; 1.822') et la deuxième plage de test (1.922 ; 1.922') pour effectuer un fonctionnement temporaire pendant lequel le composant semi-conducteur (1.1) émet de la lumière,
- ensuite, séparer le panneau (P ; P'), la première et/ou la deuxième plage de test (1.822, 1.922 ; 1.822', 1.922') étant au moins partiellement séparées de la source de lumière (1).

2. Procédé selon la revendication 1, dans lequel le tracé conducteur en pont (1.6) est mis en contact électrique avec le corps de support (1.3).

3. Procédé selon la revendication 2, dans lequel au moins un premier tracé conducteur (1.8') est fabriqué qui est mis en contact électrique avec le composant semi-conducteur (1.1) et qui présente une plage de connexion (1.821').

4. Procédé selon la revendication 1, dans lequel le tracé conducteur en pont (1.6') est mis en contact électrique avec la première face (1.11) de l'au moins un composant semi-conducteur (1.1).

5. Procédé selon la revendication 4, dans lequel au moins un premier tracé conducteur (1.8) est fabriqué qui est mis en contact électrique avec le corps de support (1.3) et qui présente une plage de connexion (1.821).

6. Procédé selon l'une quelconque des revendications précédentes, dans lequel au moins un deuxième tracé conducteur (1.9 ; 1.9') est fabriqué qui est mis en contact électrique avec le corps électriquement conducteur (1.4) et qui présente une plage de connexion (1.921 ; 1.921').

7. Procédé selon l'une quelconque des revendications précédentes, dans lequel, après l'application d'une première masse de scellement (1.5), le corps de support (1.3) et le corps électriquement conducteur (1.4) sont soumis à un processus de meulage pour fabriquer une surface (O2) opposée à la première face (1.11) du composant semi-conducteur (1.1).

8. Procédé selon l'une quelconque des revendications précédentes, dans lequel la séparation est effectuée à l'aide d'un processus de tronçonnage par abrasion.

9. Procédé selon l'une quelconque des revendications précédentes, dans lequel plusieurs premiers ensembles (100) sont fixés sur le premier support auxiliaire (4) de sorte que respectivement la première face (1.11) des composants semi-conducteurs (1.1) est disposée en étant tournée vers le premier support auxiliaire (4).

10. Procédé selon la revendication 9, dans lequel plusieurs corps électriquement conducteurs (1.4) sont fixés sur le premier support auxiliaire (4), respectivement à côté d'un corps de support (1.3), le panneau (P ; P') comprenant plusieurs corps électriquement conducteurs (1.4).

11. Procédé selon l'une quelconque des revendications précédentes, dans lequel le premier tracé conducteur (1.8 ; 1.8') et le deuxième tracé conducteur (1.9 ; 1.9') sont disposés sur la même face du panneau (P ; P').

12. Dispositif de mesure de position, comprenant une unité de capteur et un composant (10) muni d'une graduation (10.1), mobile par rapport à l'unité de capteur, l'unité de capteur comprenant une source de lumière (1) fabriquée selon un procédé selon les revendications 1 à 10 et un photodétecteur (2).

13. Dispositif de mesure de position selon la revendication 12, dans lequel le photodétecteur (2) présente une surface photosensible (2.1), la première face (1.11) du composant semi-conducteur (1.1) et la surface photosensible (2.1) étant disposées sur la même face de l'unité de capteur.

14. Dispositif de mesure de position selon la revendication 12 ou 13, dans lequel le composant (10) est pivotant par rapport à l'unité de capteur, et la graduation (10.1) est configurée comme une graduation d'angle.

15. Dispositif de mesure de position selon la revendication 12 ou 13, dans lequel le composant (10) peut être déplacé de manière linéaire par rapport à l'unité de capteur et la graduation (10.1) est configurée comme une graduation de longueur.
